Europäisches Patentamt

European Patent Office

Office européen des brevets

(11) Numéro de publication : **0 415 838 B1**

# FASCICULE DE BREVET EUROPEEN

(45) Date de publication du fascicule du brevet :
**01.03.95 Bulletin 95/09**

(51) Int. Cl.$^6$ : **G02B 21/00**

(21) Numéro de dépôt : **90402370.2**

(22) Date de dépôt : **27.08.90**

(54) **Procédé de microscopie et microscope en champ proche en réflexion.**

(30) Priorité : **28.08.89 FR 8911297**

(43) Date de publication de la demande :
**06.03.91 Bulletin 91/10**

(45) Mention de la délivrance du brevet :
**01.03.95 Bulletin 95/09**

(84) Etats contractants désignés :
**AT BE CH DE DK ES FR GB GR IT LI LU NL SE**

(56) Documents cités :
**EP-A- 0 112 401
EP-A- 0 112 402
EP-A- 0 283 256
ELECTRONICS LETTERS, vol. 22, no. 2, janvier
1986, pages 103-105; M.V. IRAVA-
NI:"Fibre-optic scanning differential interference contrast optical microscope"**

(73) Titulaire : **SIM (SOCIETE D'INVESTISSEMENT
DANS LA MICROSCOPIE) SA
16-18 Boulevard de la Marne
F-89000 Auxerre (FR)**

(72) Inventeur : **De Fornel, Frédérique
16 Rue du Recteur Bouchard
F-21000 Dijon (FR)**
Inventeur : **Goudonnet, Jean-Pierre
12F, Rue Isabelle du Portugal
F-21000 Dijon (FR)**
Inventeur : **Cerre, Nathalie
38 Rue des Chailloux
F-58000 Nevers (FR)**

(74) Mandataire : **Serin, Jean-Pierre et al
Cabinet PIERRE LOYER
77, rue Boissière
F-75116 Paris (FR)**

EP 0 415 838 B1

## Description

L'invention concerne un procédé de microscopie et un microscope en champ proche en réflexion utilisant un guide d'ondes, du type d'une fibre optique, comme sonde de ce champ.

La microscopie en champ proche conventionnelle met à profit la structure particulière d'une onde électromagnétique au voisinage d'une ouverture de diamètre inférieur (et jusqu'à une dizaine de fois supérieur) à sa longueur d'onde. Le voisinage doit ici se comprendre comme étant la zone dite de "champ proche" qui est située à une distance de l'ouverture inférieure à la longueur d'onde. Dans cette zone, l'intensité de l'onde décroît très rapidement jusqu'à atteindre la valeur de l'intensité dans la zone dite de "champ lointain" qui est calculable, d'une manière connue, par application des équations de Maxwell.

Cette décroissance très rapide de l'intensité en fonction de la distance à l'ouverture permet de relever très finement la topographie de la surface d'où est émise ou réémise la lumière, chaque variation d'intensité mesurée par des moyens appropriés correspondant à une variation de distance.

On connait de nombreux dispositifs fonctionnant suivant ce principe, aussi bien en transmission qu'en réflexion. Notamment, dans le brevet européen EP-112 401 déposé le 27 décembre 1982 au nom de International Business Machines Corporation, il est plus particulièrement remédié au problème de l'obtention d'une ouverture de diamètre faible, typiquement inférieur au micromètre, utilisable dans un microscope en champ proche optique. Dans une variante décrite dans ce document, l'ouverture reçoit la lumière transmise au travers d'un échantillon à analyser, celui-ci étant maintenu à une distance appropriée par un moyen conventionnel, tel qu'une sonde électronique mesurant un courant tunnel.

L'utilisation d'une telle sonde électronique rend néanmoins nécessaire la métallisation de l'échantillon à analyser, l'ouverture submicronique étant quant à elle déjà métallisée puisqu'elle est délimitée par une couche épaisse de métal, opaque au rayonnement de l'onde électromagnétique de mesure.

Cette double métallisation, de l'échantillon d'une part, et de la sonde optique constituée par l'ouverture submicronique d'autre part, possède de graves inconvénients.

En effet, la métallisation d'échantillons organiques, ou plus généralement diélectriques, peut constituer une gêne pour l'observation de certains phénomènes, notamment les phénomènes dynamiques ou vivants. Par ailleurs, cette métallisation peut être hétérogène ou cacher des structures de petite échelle par recouvrement. En outre, en cas de discontinuité de la couche superficielle conductrice, le contrôle de la distance à l'ouverture n'est plus assuré, ce qui conduit à une aberration topographique.

On a enfin constaté que les parois métalliques de l'ouverture submicronique et la surface métallisée de l'échantillon constituent une cavité résonante génératrice d'interférences qui viennent moduler l'intensité mesurée derrière cette ouverture et troubler cette mesure.

Par ailleurs, l'obtention d'une ouverture d'un diamètre submicronique constitue la difficulté principale de réalisation de ce type de microscope, et en limite le développement. En effet, la fabrication répétitive d'une ouverture submicronique, notamment pour un microscope en champ proche en transmission, est particulièrement délicate à mettre en oeuvre et fait d'ailleurs l'objet d'une solution décrite dans le brevet européen EP-112 402 déposé le 27 décembre 1982 par la société International Business Machines Corporation. Les diamètres des ouvertures réalisées par le procédé décrit dans ce document se situent dans une fourchette allant de à 500 nanomètres. La résolution horizontale d'un microscope en champ proche équipée d'une telle ouverture dépend alors directement de son diamètre et de sa distance à l'échantillon - la résolution est de l'ordre de la plus grande de 10 ces deux quantités -.

Les mêmes difficultés de mise en oeuvre existent pour le microscope en champ proche en réflexion. Pour ce type de microscope, on a développé des sondes optiques spécifiques fonctionnant en émission et en réception, et notamment celle décrite dans le brevet européen EP-185 782 déposée le 28 décembre 1984 au nom de la société International Business Machines Corporation. Dans ce dernier document, il est décrit un guide d'ondes composite dont la section terminale est annulaire de manière à présenter :

- une première ouverture submicronique, délimitée par une couche métallique opaque, fonctionnant en émission,
- et un anneau périphérique transparent, délimité par la première couche opaque et une seconde couche métallique opaque, fonctionnant en réception.

La mesure de la lumière réfléchie s'effectue de cette manière au travers du guide d'ondes périphérique planaire que constitue l'anneau périphérique transparent ; cette configuration est défavorable à une mesure fiable dans la mesure où une telle structure planaire introduit inévitablement des modes de propagation électromagnétiques indésirables.

Enfin, d'autres techniques microscopiques connues, et notamment la microscopie optique par contraste de phase - telle que décrite, par exemple, dans un article de la revue Electronics Letters, vol.22, no. 2, janvier 1986, pages 103-105, intitulé "Fibre-optic scanning differential interference contrast optical microscope", et écrit par M. VAEZ IRAVANI -, ou encore la microscopie optique à balayage - telle que décrite dans la demande de brevet européenne EP-283 256 déposée le 16 mars 1988 au nom de TEKTRONIX Inc. -, n'utilisent pas le phénomène de champ proche et sont, par conséquent, limitées en résolution par les phénomènes de diffraction en champ lointain.

La présente invention vise à remédier à tous ces inconvénients en proposant un procédé de microscopie en champ proche en réflexion, du type à balayage d'une surface par une sonde optique, telle que particulièrement un guide d'ondes dans lequel on injecte une onde électromagnétique avantageusement cohérente, par exemple issue d'un laser. Ce procédé est caractérisé en ce qu'on approche l'extrémité de ce guide d'ondes à une distance de la surface à étudier telle que le coefficient de couplage entre le mode propre de propagation dudit guide d'ondes et le mode de propagation du champ électrique de l'onde réfléchie par ladite surface, et guidée en retour par ce même guide d'ondes, présente un accroissement sensiblement exponentiel au fur et à mesure que ladite extrémité s'approche de cette même surface.

L'invention met ainsi en évidence un phénomène nouveau permettant d'obtenir les variations de réflectivité d'une surface réfléchissante, ainsi que sa topographie. Par la suite, on convient d'appeler "onde à modes couplés" l'onde réfléchie par la surface et guidée en retour par le guide d'ondes ; en effet, le phénomène exploité par l'invention consiste bien en un couplage de modes entre le mode propre du guide d'ondes et une onde réfléchie ayant, du fait qu'elle a été préalablement émise par le guide d'ondes, une structure modale, cette structure étant légèrement "étalée" du fait de la propagation bidirectionnelle de l'onde dans l'intervalle séparant l'extrémité du guide d'ondes de la surface réfléchissante à étudier.

Par ailleurs, étant donné que l'intensité de l'onde à modes couplés dépend directement du coefficient de couplage susmentionné, la mesure de cette intensité permet de mesurer l'évolution de ce coefficient. Selon l'invention, l'exploitation en imagerie optique d'un tel phénomène est de deux ordres, à savoir :

- selon un premier mode d'exploitation, on maintient l'extrémité du guide d'ondes à un niveau sensiblement constant au-dessus de la surface à étudier, tandis qu'on mesure l'intensité de l'onde à modes couplés, c'est-à-dire les variations du coefficient de couplage entre le mode propre de propagation dudit guide d'ondes et le mode de propagation du champ électrique de l'onde réfléchie par ladite surface. Cette mesure est ensuite interprétée comme résultant d'une variation de distance ou de réflectivité de la surface, par inversion théorique ou informatique de la relation de dépendance sensiblement exponentielle entre ladite intensité et la distance entre la surface à étudier et l'extrémité du guide d'ondes.

- selon un second mode d'exploitation, on réagit sur la position verticale de l'extrémité du guide d'ondes, de manière à maintenir constante l'intensité de l'onde à modes couplés. Cette réaction pourra avantageusement être mise en oeuvre au moyen d'un asservissement présentant une large bande passante, ce qui permettra de relever avec une grande sensibilité, et donc une résolution élevée, les déplacements verticaux de l'extrémité du guide d'ondes qui sont directement représentatifs de la topographie et/ou de la réflectivité de la surface à étudier (étant donné que la réflectivité d'un matériau dépend de son indice optique, les mesures spectroscopiques de cette surface sont également possibles).

Les domaines d'application du procédé de microscopie en champ proche en réflexion conforme à l'invention sont ainsi tout à fait comparables à ceux du microscope à balayage à effet tunnel, maintenant bien connus. En outre, la simplicité de mise en oeuvre de ce procédé est grande puisqu'il n'est pas nécessaire de fabriquer une ouverture de diamètre submicronique, ni de métalliser le guide d'ondes ou l'échantillon à étudier.

On peut ainsi utiliser une simple fibre optique, par exemple à saut d'indice du type monomode, comme guide d'ondes, une telle fibre pouvant être utilisée de trois façons principales non limitatives, à savoir :

a) la fibre est cassée en bout, de manière à présenter, en regard dé la surface réfléchissante à étudier, une face plane qui soit sensiblement perpendiculaire à l'axe longitudinal de propagation d'une onde électromagnétique dans le coeur de ladite fibre ; on a montré qu'il s'agit du cas le plus favorable pour l'obtention d'une bonne résolution (cas où la décroissance de l'intensité de l'onde à modes couplés est la plus rapide en fonction de la distance). En outre, dans cette situation, on a mis en évidence qu'il pouvait être intéressant de positionner la face plane de sortie de la fibre optique au dessus de la surface à étudier, selon une direction sensiblement orthogonale à cette surface, dans des conditions telles qu'il se produise un phénomène d'interférences constructives entre l'onde à modes couplés, et l'onde réfléchie dans cette même fibre sur sa face plane de sortie ; ce phénomène d'interférences, possible du fait de la cohérence des ondes de même longueur d'ondes, peut être évité en intercalant un gel d'indice entre la surface à étudier et ladite face plane de sortie de la fibre (par exemple, pour une fibre en silice, un gel d'indice présentant un indice optique égal à 1,458). Lorsqu'au contraire on se place dans des conditions optimales de sensibilité au phénomène d'interférences susmentionné, il est avantageux de réagir sur la position verticale de la face plane de sortie de la fibre de manière à maintenir constante l'intensité de l'onde électromagnétique résultant de ce phénomène d'interférences, alors même que cette intensité présente normalement une modulation sinusoïdale d'interfrange constant ; pour ce faire, un asservissement précis à large bande est utile afin d'éviter toute variation brutale de l'intensité recueillie, par saut d'une demie période à l'autre de la modulation. L'interfrange donnant cette période (il s'agit bien d'une périodicité spatiale) est égal simplement au rapport de la longueur d'ondes par deux fois la valeur de l'indice du milieu intermédiaire entre la face de sortie de la fibre optique et la surface réfléchissante à étudier. Cet interfrange, pour des ondes optiques, est faible (de l'ordre quelques centaines de nanomètres) et permet d'améliorer encore substantiellement la résolution de la microscopie conforme à la présente invention.

A cet égard, et toujours dans cette première utilisation d'une fibre optique comme guide d'ondes servant de sonde du champ proche créé par couplage de modes en réflexion, on distingue deux cas,

- selon que la réaction sur la position verticale de la face plane de sortie de la fibre s'effectue en mode attractif, c'est-à-dire que l'intensité de l'onde électromagnétique, résultant du phénomène d'interférences entre l'onde à modes couplés et l'onde réfléchie dans la fibre par ladite face plane, est contrôlée dans la partie descendante d'une seule période de la modulation sinusoïdale de cette même intensité,
- ou selon que la réaction sur la position verticale de la face plane de sortie de la fibre s'effectue en mode répulsif, c'est-à-dire que l'intensité de l'onde électromagnétique résultant du même phénomène d'interférences est contrôlée dans la partie descendante d'une seule période de ladite modulation sinusoïdale.

b) dans une deuxième utilisation possible d'une fibre optique monomode comme guide d'ondes, on réalise encore, à l'extrémité de cette fibre, une face plane sensiblement perpendiculaire à la direction moyenne de propagation de la lumière dans ladite fibre. Puis, on positionne cette face plane au dessus de la surface à étudier selon une direction faisant un angle substantiel avec cette même surface, de manière à éviter qu'il se produise le phénomène d'interférences constructives précédemment décrit entre l'onde à modes couplés et l'onde réfléchie dans la fibre par sa face plane de sortie, ou, du moins, de manière à éviter que ce phénomène d'interférences soit mesurable (ce qui est réalisé si la modulation sinusoïdale, qui est superposée à l'intensité de l'onde à modes couplés à décroissance sensiblement exponentielle, est d'un niveau faible ne pouvant pas être perçu par l'asservissement de position verticale de ladite face plane de sortie de la fibre).

c) dans une troisième utilisation possible d'une fibre optique monomode comme guide d'ondes, on réalise, à l'extrémité de cette fibre, une face plane faisant un angle substantiel avec la direction moyenne de propagation de la lumière dans ladite fibre. Ce cas est semblable au cas b) précédent en ce qu'il ne peut se produire aucun phénomène d'interférences constructives mesurable entre l'onde à modes couplés, et l'onde réfléchie dans cette même fibre sur sa face plane de sortie.

Bien entendu, les trois cas d'utilisation a) à c) ne sont pas limitatifs et on peut envisager d'autres structures en bout d'une fibre optique monomode utilisée selon l'invention.

D'autres caractéristiques et avantages du microscope conforme à l'invention ressortiront mieux de la description qui va suivre d'un mode de réalisation donné à titre d'exemple non limitatif d'un microscope en champ proche en réflexion, en référence aux dessins annexés sur lesquels :

- la figure 1 est une vue très schématique d'un microscope conforme à une variante préférée de réalisation de l'invention,
- la figure 2 est une vue détaillée de l'extrémité du guide d'ondes utilisé préférentiellement dans l'invention en regard avec une surface à étudier, et montrant plus particulièrement le couplage de l'onde réfléchie dans le guide d'ondes.
- la figure 3 représente un faisceau de courbes théoriques, comparées à une courbe expérimentale, montrant la dépendance entre l'intensité recueillie dans le guide d'ondes et la distance entre la surface à étudier et la face de sortie dudit guide,
- la figure 4 représente la variation de la profondeur de pénétration de l'onde électromagnétique utilisée dans une variante de l'invention en fonction du rayon du coeur de la fibre optique utilisée comme guide d'ondes.

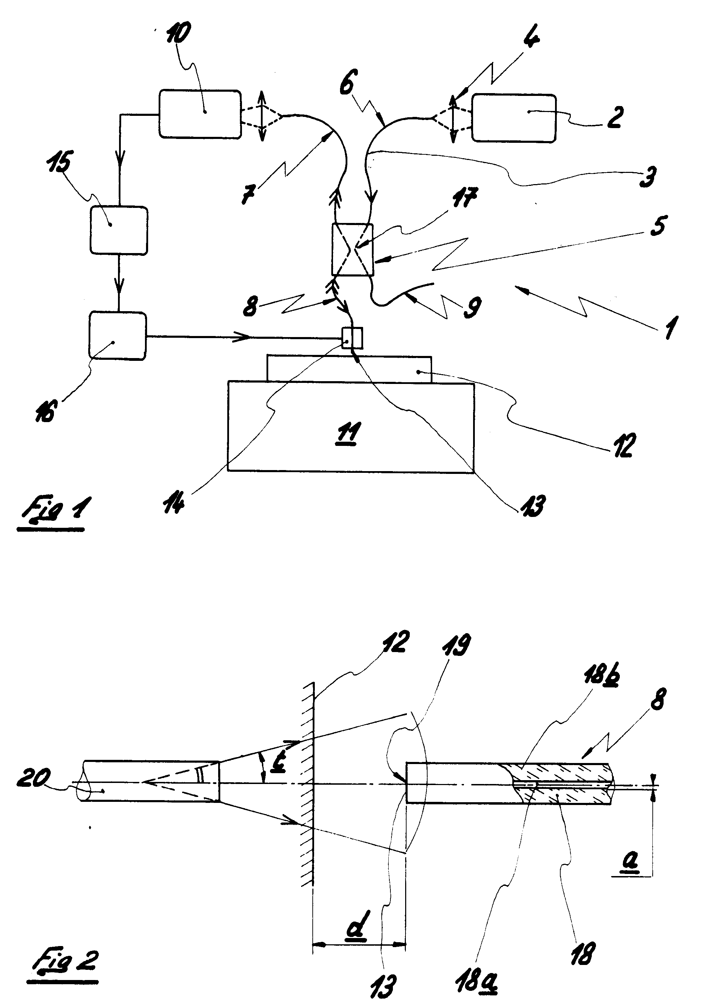

Conformément à la figure 1, et suivant une variante préférée de l'invention, un microscope en champ proche 1 est principalement constitué :

- par une source de lumière 2, telle qu'une cavité laser, ou une diode électroluminescente (par exemple "à bande étroite"), couplée à une fibre 3 par des moyens optiques 4 appropriés. Ces moyens 4 peuvent par exemple être une simple lentille convergente à courte focale du type à fort grossissement pour microscope optique conventionnel.
- par un coupleur optique 5 à fibres optiques, réalisé par exemple par un procédé de fusion/étirage, ce coupleur 5 comportant deux voies de transmission 6 et 7 en entrée et deux voies de transmission 8 et 9 en sortie. La fibre optique 3 peut avantageusement être celle qui constitue la voie 6 du coupleur 5 - de cette manière, on conserve la qualité de l'onde électromagnétique émise par la source 2 sur tout son trajet, en évitant les interfaces fibre/fibre -.

- par un détecteur de photons 10, tel que par exemple un photomultiplicateur, couplé à la voie 7 du coupleur de fibres 5. Ce détecteur 10 reçoit et mesure la lumière se propageant dans le coupleur 5 dans le sens inverse de celui de l'émission.

- par un support antivibratoire conventionnel 11, associé éventuellement à un moyen conventionnel de balayage ; ce moyen de balayage, de précision typiquement micromètrique, permet de faire balayer latéralement la surface réfléchissante 12 à étudier par l'extrémité 13 de l'une des voies 8 ou 9 du coupleur 5, par exemple la voie 8 (dans ce cas, la voie 9 n'est pas utilisée, ou sert à effectuer une mesure de référence de l'intensité de l'onde émise par la source 2).

- par un moyen conventionnel de positionnement vertical 14 de l'extrémité 13 de la voie 8 par rapport à la surface réfléchissante 12. Ce moyen de positionnement vertical 14 peut également servir au déplacement latéral "fin" - c'est-à-dire submicrométrique - de l'extrémité 13. Il peut être relié, par un dispositif à contre-réaction 15, à un microordinateur 16, contrôlant notamment le signal reçu par le détecteur 10 ; ce signal représente l'intensité de la lumière se propageant en retour dans le coupleur 5.

On notera que le moyen de positionnement 14 peut être un dispositif comportant, par exemple, un tube piezoélectrique, ou un ensemble de cristaux piezoélectriques agencés de manière appropriée (du type connu notamment sous le nom de "bimorphs").

Dans ces conditions, l'utilisation du microscope 1 peut être ainsi résumée. La lumière issue de la source 2 se propage à travers la fibre 3 constituant la voie 6 du coupleur 5, jusqu'à la zone de couplage 17 dudit coupleur 5, où on a effectué la fusion/étirage des fibres composant ledit coupleur 5. Une partie connue de la lumière (par exemple 50%) se propage alors dans la voie de transmission 8 de sortie du coupleur 5, jusqu'à l'extrémité 13 de ladite voie 8.

Conformément à la figure 2, la voie 8 est une fibre optique 18 à saut d'indice, avec $n_0$ l'indice réel du coeur 18a et $n_1$ l'indice de la gaine 18b. L'extrémité 13 de cette fibre 18 se présente sous la forme d'une face plane 19 sensiblement perpendiculaire à la direction de propagation de la lumière dans ladite fibre 18. La lumière est alors émise vers la surface réfléchissante 12, dont la topographie et la composition sont inconnues, puis elle se réfléchit et revient en direction de l'extrémité 13 où elle se couple au mode propre de propagation de la fibre 18. On a choisi ici de considérer le cas décrit en a) dans le préambule, c'est-à-dire qu'on se place dans des conditions de fonctionnement telles qu'il puisse se produire un phénomène d'interférences constructives entre l'onde à modes couplés et l'onde réfléchie directement sur la face plane 19 dans la fibre 18, mais on décrira tout d'abord le phénomène de couplage de modes conforme à l'invention, sans tenir compte de ce phénomène d'interférences qu'on peut facilement éliminer au moyen d'un gel d'indice adéquat, ou en inclinant la face plane 19 par rapport à la surface à étudier (cas b du préambule).

La lumière se propageant en retour dans la voie 8 est ainsi modulée par la surface réfléchissante 12. Elle traverse alors la zone de couplage 17 du coupleur 5 et une partie de l'intensité de cette lumière (par exemple 50%) passe dans la voie 7 dudit coupleur 5 où elle est détectée en bout par le détecteur 10.

On comprendra mieux les mécanismes physiques mis en jeu en considérant, conformément à la figure 2, la structure des ondes électromagnétiques émise et réfléchie dans la zone de "champ proche" située entre la face plane 19 de l'extrémité 13 de la fibre 18 et la surface réfléchissante 12.

On montre, par la résolution des équations de Maxwell combinées à des conditions aux limites appropriées, que seule varie la composante radiale du champ électrique d'une onde électromagnétique se propageant dans la fibre 18. Cette composante radiale s'écrit sous la forme :

- équation (i) :

$$J_0(ur/a)$$

à l'intérieur du coeur 18a de rayon a de la fibre 18,

- équation (ii) :

$$(J_0(u)/K_0(v)) * K_0(vr/a)$$

à l'extérieur du coeur 18a et à l'intérieur de la gaine 18b de la fibre 18,

avec r le rayon, u et v vérifiant des équations spécifiques fonctions de a, des indices du coeur 18a et de la gaine 18b, et des constantes de propagation de l'onde électromagnétique (vecteurs d'onde). Les fonctions $J_0$ et $K_0$ sont les fonctions de Bessel d'ordre 0.

La lumière est émise en bout de la fibre 18 dans un cône d'ouverture numérique qui dépend du saut d'indice $(n_1-n_0)$ de ladite fibre 18. La lumière réfléchie par la surface réfléchissante 12 peut être considérée comme provenant d'une fibre virtuelle 20 symétrique de la fibre 18 par rapport au plan délimité par ladite surface 12. Sur la figure 2, on a représenté la lumière réfléchie, issue de la fibre virtuelle 20, avec un angle d'ouverture t. On a également représenté par d la distance séparant la surface réfléchissante 12 de la face plane 19 de l'extrémité 13 de la fibre 18.

Dans ces hypothèses, seule varie la composante radiale du champ électrique de l'onde électromagnétique réfléchie issue de la fibre virtuelle 20, cette variation s'écrivant de la même façon que la variation radiale de l'onde incidente issue de la fibre 18 ; tout se passe alors comme si la fibre virtuelle 20 avait un coeur de rayon égal à a/alpha, alpha étant un facteur géométrique tenant compte de la divergence dans l'air du mode de propagation de l'onde réfléchie. Il convient donc de remplacer a par a/alpha dans les équations (i) et (ii) pour trouver les expressions de la composante radiale du champ électrique de l'onde réfléchie.

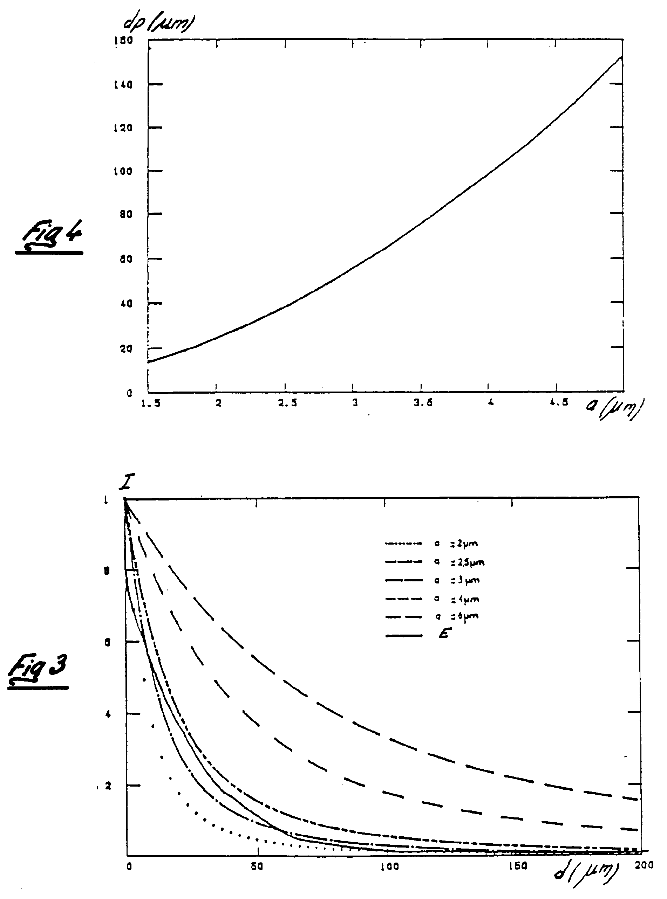

L'intensité recueillie par le détecteur 10 est proportionnelle au coefficient de couplage entre le mode de propagation de l'onde réfléchie dans l'air et le mode propre de propagation de la fibre 18, l'onde couplée en résultant étant ici encore appelée "onde à modes couplés" ; la valeur du coefficient de couplage se détermine, par exemple numériquement, en calculant l'intégrale de recouvrement des deux modes. En prenant, comme hypothèse supplémentaire, le cas d'une ouverture numérique constante, ce qui est tout à fait réalisable, on a obtenu un faisceau de courbes, représenté et référencé sur la figure 3, montrant la dépendance existant entre l'intensité de l'onde à modes couplés recueillie sur le détecteur 10 et la distance $d$.

On constate la décroissance très rapide, sensiblement exponentielle, de cette intensité en fonction de la distance $d$.

Cette propriété est comparable à la propriété de décroissance très rapide de l'intensité au voisinage d'une ouverture de diamètre inférieur à la longueur d'ondes, qui est utilisée dans un microscope en champ proche conventionnel : dans ce dernier cas, la décroissance résulte cependant du couplage de trois ondes évanescentes, l'une créée en incidence par l'ouverture, la deuxième réfléchie par la surface à étudier, et la troisième créée en réflexion par cette même ouverture.

On notera que le "champ proche" d'une fibre utilisée dans les conditions de l'invention est plus "étalé" que le champ proche d'une ouverture submicronique, et on constate, en particulier, que la distance $d$ peut être très supérieure à la longueur d'ondes de l'onde électromagnétique émise par la source 2.

Les applications d'une décroissance rapide, voire quasiment exponentielle, de l'intensité sont les mêmes dans les deux cas, c'est-à-dire concernent l'étude spectroscopique et l'étude topographique des surfaces, avec une résolution améliorée d'au moins un ordre de grandeur par rapport à la microscopie optique classique (qui est limitée par la diffraction).

Afin de comparer les capacités d'un microscope à champ proche conventionnel et du microscope 1 conforme à l'invention, il convient de comparer leurs résolutions respectives, tant verticale que latérale.

a) Résolution verticale

Il est courant d'assimiler à une décroissance exponentielle la décroissance rapide de l'intensité de "l'onde de mesure" (c'est-à-dire de l'onde transmise dans le cas d'un microscope en transmission, ou de l'onde réfléchie dans le cas d'un microscope en réflexion) en fonction de la distance séparant la surface 12 à étudier et l'extrémité de la sonde optique servant à capter ladite "onde de mesure" (ouverture submicronique dans un cas; et fibre optique 18 dans l'autre cas). L'hypothèse de la décroissance exponentielle peut souvent être vérifiée expérimentalement, au moins dans un domaine de distance qu'on pourra ainsi utiliser. L'intensité de "l'onde de mesure" peut alors s'écrire :

$$\underline{\text{équation (iii)}} \qquad I = I_0 \exp(-2d/d_p)$$

On a coutume de nommer $d_p$ la profondeur de pénétration de "l'onde de mesure" ; elle caractérise la résolution verticale qu'il est possible d'obtenir avec le microscope utilisé.

a1) Pour le microscope en champ proche conventionnel, il a été démontré que cette résolution se situe dans une fourchette allant de quelques nanomètres à quelques centaines de micromètres

a2) Dans le cas du microscope 1 conforme à l'invention, on a représenté, sur la figure 4, la variation de la quantité $d_p$ en fonction du rayon a du coeur 18a de la fibre optique 18, constituant la voie 8, et servant de sonde optique pour ce microscope 1 (la source de lumière 2 était un laser Hélium-Néon émettant à une longueur d'onde de 632 nanomètres, et l'ouverture numérique était constante et égale à 2,3). On remarque que la profondeur de pénétration $d_p$ décroît sensiblement avec le rayon a du coeur 18a de la fibre optique 18. Cette courbe théorique a été vérifiée expérimentalement en quelques uns de ses points, et notamment pour une fibre 18 de rayon a de coeur égal à 2,5 micromètres, et de diamètre de gaine égal à 125 micromètres ; pour une telle fibre 18, $d_p$ est égale à une valeur proche de 40 micromètres. Sur la figure 3, on a également comparé le faisceau de courbes théoriques à la courbe E représentant la décroissance expérimentale de l'intensité de l'onde à modes couplés dans les conditions précédemment mentionnées.

On peut diminuer notablement $d_p$ en jouant sur divers paramètres :

- en diminuant la longueur d'ondes de l'onde émise par la source de lumière 2, la limite en longueur d'ondes étant donnée par l'existence des sources à faible longueur d'onde et par la longueur d'onde dite "de coupure" en deçà de laquelle un rayonnement électromagnétique ne peut pas se propager dans la fibre 18 (actuellement 180 nanomètres pour une fibre en silice).

- en diminuant le rayon a du coeur 18a de la fibre optique 18, par exemple par étirage de l'extrémité 13 de ladite fibre 18 - on peut aller jusqu'à un diamètre de coeur égal à 500 nanomètres sans problème, la résolution étant dégradée au-delà, en raison de "l'élargissement" du mode de propagation propre dans la fibre 18 lorsque le coeur 18a est d'un diamètre trop petit -.
- en faisant varier de manière adéquate les caractéristiques géométriques de la fibre 18, c'est-à-dire ses indices de coeur et de gaine, $n_0$ et $n_1$, de manière à faire varier son ouverture numérique.

On peut estimer que la meilleure résolution verticale qu'il est possible d'atteindre avec le microscope 1 conforme à l'invention est proche de 10 nanomètres, pour une fibre 18 en silice dont le coeur 18a a un diamètre de 500 nanomètres, et pour une onde électromagnétique "de mesure", de longueur d'ondes égale à 205 nanomètres, issue d'un laser à colorant, et doublée en fréquence au moyen de cristaux non linéaires.

Cette résolution peut encore être améliorée d'au moins un ordre de grandeur si on se place dans des conditions de sensibilité au phénomène d'interférences déjà mentionné, puisque, même si la décroissance de l'intensité n'est plus exactement exponentielle, l'interfrange spatiale de la modulation sinusoïdale de l'intensité résultant de ce phénomène peut atteindre de très faibles valeurs (dans l'air, et pour la longueur d'ondes du laser Hélium-Néon, la demie période d'oscillation vaut environ 150 nanomètres, ce qui permet d'asservir l'intensité avec une très grande sensibilité).

Etant observée la simplicité de mise en oeuvre du microscope 1 conforme à l'invention, cette résolution constitue la meilleure résolution jamais atteinte à ce jour pour l'observation de surfaces difficilement métallisables.

b) Résolution latérale

b1) La résolution latérale d'un microscope en champ proche conventionnel se situe à l'intérieur d'une fourchette allant de quelques dizaines de nanomètres à quelques millimètres. Elle est déterminée, comme on l'a déjà dit, par la taille de l'ouverture servant de sonde optique, et par les phénomènes d'interférence se produisant du fait de l'excitation des modes de la cavité constituée par les parois métallisées de la surface 12 observée et le trou délimité par un matériau opaque conducteur.

b2) On a montré expérimentalement que la résolution latérale du microscope 1 conforme à l'invention est nettement inférieure au diamètre 2a du coeur 18a de la fibre optique 18 constituant la voie 8 du coupleur 5. Dans le cas où ce diamètre est égal à 5 micromètres, on a pu observer une surface réfléchissante 12 constituée par un réseau industriel au pas de 12 micromètres avec une résolution latérale meilleure que 500 nanomètres (une telle résolution a, en outre, été obtenue par exploitation de l'enregistrement direct de l'intensité de l'onde à modes couplés, sans traitement mathématique postérieur courant en pareil cas et visant à extraire de la mesure le bruit ou les dérives répétitives). La longueur d'onde de "l'onde de mesure" était de 632 nanomètres (laser Hélium-Néon).

On constate donc que, contrairement au microscope en champ proche conventionnel, la résolution latérale est largement inférieure au diamètre 2a du coeur 18a de la fibre 18 servant de sonde optique (ce diamètre est l'équivalent du diamètre de l'ouverture dans le cas du microscope conventionnel).

On peut ainsi raisonnablement appliquer un facteur d'échelle à ces résultats, et avec la même source 2 et une fibre 18 dont le diamètre de coeur vaut 500 nanomètres, on peut obtenir une résolution latérale meilleure que 50 nanomètres.

On doit également noter que la mesure précédemment mentionnée a été effectuée dans des conditions expérimentales défavorables pour lesquelles le moyen conventionnel de positionnement vertical 14 (fig.1) de l'extrémité 13 de la fibre 18 par rapport à la surface réfléchissante 12 n'était assujetti à aucune contre-réaction (par exemple au moyen du dispositif à contre-réaction 15) ; or on sait tout le bénéfice que l'on peut tirer, vis à vis de la précision, d'une telle contre-réaction, qui permet au détecteur 10 d'enregistrer un signal variant de manière très sensible, du fait que l'on maintient alors la distance d à une valeur correspondant à la zone de forte décroissance de l'intensité de l'onde réfléchie et transmise par le coupleur 5.

Suivant une autre variante de réalisation du microscope en champ proche 1 objet de l'invention, la résolution verticale (et de même la résolution latérale) peut être encore augmentée. Dans cette variante, on utilise, comme sonde optique, une fibre optique 18 à laquelle on fait subir une attaque chimique de manière à en effiler l'extrémité 13 ; après cette attaque chimique (réalisée de manière connue au moyen d'un acide), l'extrémité de la fibre optique 18 est coupée de manière à présenter une face plane 19 sensiblement perpendiculaire à la direction de propagation de la lumière dans ladite fibre 18. L'extrémité 13 se présente alors comme une pointe, et la gaine 18b, entourant le coeur 18a de la fibre optique 18, est très amincie. De cette façon, le mode de propagation principal à l'intérieur de la fibre 18 peut être très étroit ; en effet, une onde se propageant à l'extrémité 13 de la fibre optique 18 "voit" alors trois milieux :

- le coeur 18a, d'indice optique n0,

- la gaine 18b, d'indice optique n1,
- et l'air, d'indice optique égal à 1, qui vient, du fait de cet indice très inférieur à n1 et à n0, diminuer la "largeur" du mode de propagation dans la fibre optique 18.

Dans toute la description qui précède, il est clair qu'il n'a nulle part été tenu compte des modes de propagation dans la fibre optique 18 autres que le mode de propagation principal. Cette approche est tout à fait justifiée car on peut très facilement, et de manière connue, faire en sorte que certains modes ne se propagent pas (ce qui revient à dire que toute l'énergie se propage sur le mode principal). Notamment, l'interface entre la gaine 18b et le coeur 18a de la fibre optique 18 est responsable de la propagation potentielle de modes parasites dénommés "modes de gaine" ; l'opération dite de "vidage" de la fibre optique 18 permet d'en éliminer la propagation, une technique particulièrement efficace pour ce faire étant de disposer sur les fibres optiques des voies 6 et 7 du coupleur 5 un "liquide d'indice" (c'est-à-dire un liquide dont l'indice est égal à celui de la gaine des fibres).

Il ressort bien de la description précédente que le microscope 1 de champ proche utilisant comme sonde optique un guide d'ondes, tel que notamment une fibre optique 18, résout de manière avantageuse les inconvénients liés aux microscopes de champ proche conventionnels et permet l'observation spectroscopique et l'observation topographique de surfaces réfléchissantes 12 difficilement métallisables. L'observation spectroscopique est effectuée par diverses techniques visant à moduler l'intensité de l'onde à modes couplés en fonction du "paramètre spectroscopique" que l'on veut extraire, par exemple la longueur d'onde. Cette observation renseigne sur la nature d'une surface réfléchissante 12, sa topographie pouvant être connue, par exemple, par un premier balayage de ladite surface 12 sans modulation d'aucun paramètre.

On peut également utiliser le microscope 1 conforme à l'invention comme un capteur de distance comparable à un capteur de distance utilisant un effet tunnel électronique (technique dérivée du microscope à effet tunnel électronique). Ce capteur purement optique permet de s'affranchir de toute métallisation. La distance est alors contrôlée, dans ce cas, pour des valeurs plus grandes que dans le cas d'un effet tunnel électronique, ce qui procure d'autres avantages, et notamment celui d'éviter une proximité trop grande entre le capteur de distance et la surface 12 à maintenir à distance - une telle proximité est "dangereuse" pour la surface 12, puisqu'une variation brutale, ou une dérive (c'est-a-dire une pente), peut provoquer la mise en contact physique dudit capteur et de ladite surface 12 -. Dans cette application, on suppose que la surface est homogène, et que seule une variation de distance est responsable d'une variation d'intensité de l'onde à modes couplés.

Etant donné que diverses modifications peuvent être apportées aux formes de réalisation décrites ci-dessus sans se départir du cadre de l'invention, il est entendu que tous les détails contenus dans la description qui vient d'être donnée ou représentés dans les dessins annexés sont donnés à titre d'illustration de l'invention et ne sont donc pas limitatifs.

Notamment, on pourrait utiliser tout guide d'ondes autre qu'une fibre optique, ou encore une fibre optique non monomode. On peut également envisager d'utiliser un autre coupleur optique qu'un coupleur de fibres optiques réalisé par un procédé de fusion/étirage.

Le domaine de l'invention est plus particulièrement celui de la microscopie à balayage, par des moyens purement optiques, et avec des résolutions nanométriques. On peut également destiner l'invention au contrôle optique de la distance entre une surface donnée et un instrument à déplacer au-dessus de cette surface, et notamment tout instrument du type servant à la microlithographie des circuits intégrés.

## Revendications

1. Procédé de microscopie en champ proche en réflexion, du type à balayage d'une surface (12) par une sonde optique (8), telle que particulièrement un guide d'ondes dans lequel on injecte une onde électromagnétique avantageusement cohérente, par exemple issue d'un laser (2), procédé caractérisé en ce qu'on approche l'extrémité (13) de ce guide d'ondes à une distance (d) de la surface à étudier telle que le coefficient de couplage entre le mode propre de propagation dudit guide d'ondes et le mode de propagation du champ électrique de l'onde réfléchie par ladite surface, et guidée en retour par ce même guide d'ondes, présente un accroissement sensiblement exponentiel au fur et à mesure que ladite extrémité s'approche de cette même surface.

2. Procédé de microscopie en champ proche en réflexion suivant la revendication 1, caractérisé en ce qu'on réagit sur la position verticale de l'extrémité du guide d'ondes servant de sonde optique, de manière à maintenir constant le coefficient de couplage entre le mode propre de propagation dudit guide d'ondes et le mode de propagation du champ électrique de l'onde réfléchie, et guidée en retour par ce même guide d'ondes.

3. Procédé de microscopie en champ proche en réflexion suivant la revendication 1, caractérisé en ce que l'extrémité du guide d'ondes servant de sonde optique est maintenu à un niveau sensiblement constant au-dessus de la surface à étudier, tandis qu'on mesure les variations du coefficient de couplage entre le mode propre de propagation dudit guide d'ondes et le mode de propagation du champ électrique de l'onde réfléchie par ladite surface.

4. Procédé de microscopie en champ proche en réflexion suivant la revendication 2, utilisant une fibre optique préférentiellement monomode en tant que guide d'ondes, caractérisé en ce qu'on réalise, à l'extrémité de cette fibre optique, une face plane (19) sensiblement perpendiculaire à la direction moyenne de propagation de la lumière dans ladite fibre, puis, en ce qu'on positionne cette face plane au dessus de la surface à étudier, selon une direction sensiblement orthogonale à cette surface, dans des conditions telles qu'il se produise un phénomène d'interférences constructives entre l'onde réfléchie par ladite surface, et guidée en retour par ladite fibre optique, et l'onde réfléchie dans cette même fibre sur sa face plane de sortie, et enfin, en ce qu'on réagit sur la position verticale de cette même face plane de manière à maintenir constante l'intensité de l'onde électromagnétique résultant de ce phénomène d'interférences, alors même que cette intensité présente une modulation sinusoïdale d'interfrange constant.

5. Procédé de microscopie en champ proche en réflexion suivant la revendication 4, caractérisé en ce qu'on positionne la face plane de sortie de la fibre optique utilisée comme guide d'ondes, au dessus de la surface à étudier, dans des conditions telles que la réaction sur la position verticale de cette même face plane puisse s'effectuer en mode attractif, c'est-à-dire que l'intensité de l'onde électromagnétique, résultant du phénomène d'interférences entre l'onde réfléchie par la surface à étudier et l'onde réfléchie par ladite face plane, soit contrôlée dans la partie montante d'une seule période de la modulation sinusoïdale de cette même intensité.

6. Procédé de microscopie en champ proche en réflexion suivant la revendication 4, caractérisé en ce qu'on positionne la face plane de sortie de la fibre optique utilisée comme guide d'ondes, au dessus de la surface à étudier, dans des conditions telles que la réaction sur la position verticale de cette même face plane puisse s'effectuer en mode répulsif, c'est-à-dire que l'intensité de l'onde électromagnétique, résultant du phénomène d'interférences entre l'onde réfléchie par la surface à étudier et l'onde réfléchie par ladite face plane, soit contrôlée dans la partie descendante d'une seule période de la modulation sinusoïdale de cette même intensité.

7. Procédé de microscopie en champ proche en réflexion suivant la revendication 2, utilisant une fibre optique préférentiellement monomode en tant que guide d'ondes, caractérisé en ce qu'on réalise, à l'extrémité de cette fibre optique, une face plane (19) sensiblement perpendiculaire à la direction moyenne de propagation de la lumière dans ladite fibre, puis, en ce qu'on positionne cette face plane au dessus de la surface à étudier, selon une direction faisant un angle substantiel avec cette même surface, dans des conditions telles qu'il ne puisse se produire aucun phénomène d'interférences constructives mesurable entre l'onde réfléchie par ladite surface, et guidée en retour par ladite fibre optique, et l'onde réfléchie dans cette même fibre sur sa face plane de sortie.

8. Procédé de microscopie en champ proche en réflexion suivant la revendication 2, utilisant une fibre optique préférentiellement monomode en tant que guide d'ondes, caractérisé en ce qu'on réalise, à l'extrémité de cette fibre optique, une face plane faisant un angle substantiel avec la direction moyenne de propagation de la lumière dans ladite fibre, puis, en ce qu'on positionne cette même fibre au dessus de la surface à étudier, selon une direction sensiblement orthogonale à cette même surface, dans des conditions telles qu'il ne puisse se produire aucun phénomène d'interférences constructives mesurable entre l'onde réfléchie par ladite surface, et guidée en retour par ladite fibre optique, et l'onde réfléchie dans cette même fibre sur sa face plane de sortie.

9. Microscope en champ proche en réflexion du type à balayage d'une surface à examiner (12), comprenant une sonde optique (18) constituant un guide d'ondes ayant une première extrémité (13) et une deuxième extrémité, des moyens de déplacement vertical (14) et latéral (11) de ladite sonde (18) avec une précision inférieure au nanomètre, au-dessus de la surface à examiner (12), une source (2) telle qu'un laser générant une onde électromagnétique cohérente, un détecteur d'ondes électromagnétiques (10), et des moyens de liaison (5, 6, 7, 8) reliant ladite deuxième extrémité du guide d'ondes (18) à ladite source (2), caractérisé en ce que lesdits moyens de liaison comprennent un coupleur optique bidirectionnel (5) possédant une première (6) et une deuxième (7) voies de transmission en entrée (6, 7) et au moins une (8) voie de transmission en sortie, la première (6) desdites voies (6, 7) de transmission en entrée étant reliée à la source (2), la deuxième étant reliée au détecteur (10), ladite au moins une voie de transmission en sortie (8) étant reliée audit guide d'ondes (18), l'onde électromagnétique émise par la première extrémité (13) du guide d'ondes (18) étant réfléchie par la surface à examiner (12) de manière à revenir en direction de cette extrémité (13) et de se coupler au mode propre de propagation du guide d'ondes (18) tout en étant guidée vers le détecteur en passant par la voie de transmission en sortie (8), le coupleur (5) et la deuxième voie en entrée (7), l'extrémité du guide d'ondes étant approchée à une distance de la surface telle que le coefficient de couplage entre le mode propre de propagation dudit guide d'ondes et le mode de propagation du champ électrique de l'onde réfléchie présente un accroissement sensiblement exponentiel au fur et à mesure que ladite extrémité s'approche de cette surface.

10. Microscope en champ proche suivant la revendication 9, caractérisé en ce que le coupleur comporte une deuxième voie de transmission en sortie (9) conçue et agencée de manière à servir à effectuer une mesure de référence de l'intensité de l'onde émise par la source (2).

11. Microscope en champ proche suivant la revendication 9, caractérisé en ce que le détecteur (10) est relié, par un système d'asservissement (15), aux moyens conventionnels de déplacement vertical (14) de l'extrémité dudit guide d'ondes.

12. Microscope en champ proche suivant l'une quelconque des revendications 9 à 11, caractérisé en ce que le guide d'ondes servant de sonde optique est constitué par une fibre optique (18) servant de voie de transmission (8) en sortie du coupleur optique (5).

13. Microscope en champ proche suivant la revendication 12, caractérisé en ce que l'extrémité (13) de la fibre optique (18) servant de guide d'ondes se présente sous la forme d'une face plane (19) sensiblement perpendiculaire à la direction moyenne de propagation de la lumière dans ladite fibre (18).

14. Microscope en champ proche suivant l'une quelconque des revendications 12 ou 13, caractérisé en ce que la fibre optique (18) servant de guide d'ondes est étirée à son extrémité (13) de manière à présenter un coeur (18a) dont le diamètre corresponde au mode principal de propagation le plus "étroit" d'une onde électromagnétique dans ladite fibre (18), dans des conditions d'utilisation données, notamment dépendantes de la longueur d'ondes de l'onde électromagnétique émise par la source (2), de la nature des fibres optiques composant les voies de transmission (6,7,8,9) du coupleur (5), et de l'ouverture numérique de la fibre optique (18) servant de guide d'ondes.

15. Microscope en champ proche suivant l'une quelconque des revendications 12 à 14, caractérisé en ce que la gaine (18b) de la fibre optique (18) servant de guide d'ondes est amincie à l'extrémité (13) de ladite fibre (18), qui se présente alors sous la forme d'une pointe, la face terminale (19) de cette fibre (18) étant par ailleurs plane et sensiblement perpendiculaire à la direction de propagation de la lumière dans ladite fibre (18).

16. Microscope en champ proche suivant la revendication 12, caractérisé en ce que l'extrémité (13) de la fibre optique (18) servant de guide d'ondes se présente sous la forme d'une face plane (19) faisant un angle substantiel avec la direction moyenne de propagation de la lumière dans ladite fibre (18).

## Patentansprüche

1. Verfahren der Reflexions-Nahfeldmikroskopie der Art mit Abtastung einer Oberfläche (12) mittels eines optischen Meßfühlers (8), wie insbesondere eines Wellenleiters, in den man eine vorzugsweise kohärente, z. B. von einem Laser (2) stammende, elektomagnetische Welle einleitet, **dadurch gekennzeichnet, daß** man das Ende (13) des Wellenleiters bis auf einen Abstand (d) von der zu untersuchenden Oberfläche so annähert, daß der Kopplungskoeffizient zwischen der Ausbreitungseigenmode des Wellenleiters und der Ausbreitungsmode des elektrischen Feldes der durch die Oberfläche reflektierten und durch denselben Wellenleiter zurückgeführten Welle in dem Maße, wie sich das Ende an diese Oberfläche annähert, eine im wesentlichen exponentielle Zunahme zeigt.

2. Verfahren der Reflexions-Nahfeldmikroskopie nach Anspruch 1, dadurch gekennzeichnet, daß man auf die vertikale Lage des Endes des als optischer Meßfühler dienenden Wellenleiters so reagiert, daß der Kopplungskoeffizient zwischen der Ausbreitungseigenmode des Wellenleiters und der Ausbreitungsmode des elektrischen Feldes der reflektierten und durch denselben Wellenleiter zurückgeführten Welle konstant bleibt.

3. Verfahren der Reflexions-Nahfeldmikroskopie nach Anspruch 1, dadurch gekennzeichnet, daß das Ende des als optischer Meßfühler dienenden Wellenleiters in einer im wesentlichen konstanten Höhe über der zu untersuchenden Oberfläche gehalten wird, während man die Änderungen des Kopplungskoeffizienten zwischen der Ausbreitungseigenmode des Wellenleiters und der Ausbreitungsmode des elektrischen Feldes der durch die Oberfläche reflektierten Welle mißt.

4. Verfahren der Reflexions-Nahfeldmikroskopie nach Anspruch 2, bei dem eine optische Faser, vorzugsweise eine Monomodefaser, als Wellenleiter eingesetzt wird, dadurch gekennzeichnet, daß am Ende dieser optischen Faser eine ebene, im wesentlichen zur mittleren Ausbreitungsrichtung des Lichtes in der Faser senkrecht verlaufende Fläche (19) geschaffen wird, dann diese ebene Fläche oberhalb der zu untersuchenden Oberfläche, in einer im wesentlichen zu dieser Oberfläche orthogonalen Richtung unter solchen Bedingungen angeordnet wird, daß sich zwischen der durch die Oberfläche reflektierten und durch die optische Faser zurückgeleiteten Welle und der in derselben Faser an deren ebener Ausgangsfläche reflektierten Welle ein Phänomen konstruktiver Interferenzen ausbildet, und zuletzt auf die vertikale Lage derselben ebenen Fläche so reagiert wird, daß die Intensität der aus diesem Interferenz-Phänomen resultierenden elektromagnetischen Welle konstant bleibt, wobei diese Intensität eine konstante sinusförmige Modulation des Streifenabstands zeigt.

5. Verfahren der Reflexions-Nahfeldmikroskopie nach Anspruch 4, dadurch gekennzeichnet, daß die ebene Ausgangsfläche der als Wellenleiter verwendeten optischen Faser oberhalb der zu untersuchenden Oberfläche unter solchen Bedingungen angeordnet wird, daß die Reaktion auf die vertikale Lage dieser ebenen Fläche auf attraktive Weise vorgenommen werden kann, d. h., daß die Intensität der elektromagnetischen Welle, die von dem Interferenz-Phänomen zwischen der durch die zu untersuchende Oberfläche reflektierten Welle und der durch die ebene Fläche reflektierten Welle resultiert, im ansteigenden Bereich einer einzigen Periode der sinusförmigen Modulation dieser Intensität geregelt wird.

6. Verfahren der Reflexions-Nahfeldmikroskopie nach Anspruch 4, dadurch gekennzeichnet, daß die ebene Ausgangsfläche der als Wellenleiter verwendeten optischen Faser oberhalb der zu untersuchenden Oberfläche unter solchen Bedingungen angeordnet wird, daß die Reaktion auf die vertikale Lage dieser ebenen Fläche in einer repulsiven Weise vorgenommen werden kann, d.h., daß die Intensität der elektromagnetischen Welle, die von dem Interferenz-Phänomen zwischen der durch die zu untersuchende Oberfläche reflektierten Welle und der durch die ebene Fläche reflektierte Welle resultiert, im abfallenden Bereich einer einzigen Periode der sinusförmigen Modulation dieser Intensität geregelt wird.

7. Verfahren der Reflexions-Nahfeldmikroskopie nach Anspruch 2, bei dem eine optische Faser, vorzugsweise eine Monomodefaser, als Wellenleiter eingesetzt wird, dadurch gekennzeichnet, daß am Ende der optischen Faser eine im wesentlichen zur mittleren Ausbreitungsrichtung des Lichtes in der Faser senkrecht verlaufende ebene Fläche geschaffen wird, dann diese ebene Fläche oberhalb der zu untersuchenden Oberfläche in einer mit dieser Oberfläche einen beträchlichen Winkel bildenden Richtung unter solchen Bedingungen angeordnet wird, daß kein meßbares Phänomen konstruktiver Interferenzen zwischen der durch die Oberfläche reflektierten und durch die optische Faser zurückgeleiteten Welle und der in dieser Faser an deren ebener Ausgangsfläche reflektierten Welle auftreten kann.

8. Verfahren der Reflexions-Nahfeldmikroskopie nach Anspruch 2, bei dem eine optische Faser, vorzugsweise eine Monomodefaser, als Wellenleiter eingesetzt wird, dadurch gekennzeichnet, daß am Ende dieser optischen Faser eine ebene Fläche geschaffen wird, die mit der mittleren Ausbreitungsrichtung des Lichtes in dieser Faser einen beträchtlichen Winkel bildet, und sodann diese Faser oberhalb der zu untersuchenden Oberfläche in einer zu dieser Oberfläche im wesentlichen orthogonalen Richtung unter solchen Bedingungen angeordnet wird, daß kein meßbares Phänomen konstruktiver Interferenzen zwischen der durch die Oberfläche reflektierten und durch die optische Faser zurückgeleiteten Welle und der in dieser Faser an deren ebener Ausgangsfläche reflektierten Welle auftreten kann.

9. Reflexions-Nahfeldmikroskop der Art mit Abtastung einer zu untersuchenden Oberfläche (12), mit einem optischen Meßfühler (18), der aus einem ein erstes Ende (13) und ein zweites Ende aufweisenden Wellenleiter besteht, mit Mitteln zur vertikalen (14) und seitlichen Verschiebung (11) dieses Meßfühlers (18) mit einer subnanometrischen Genauigkeit, mit einer oberhalb der zu untersuchenden Oberfläche (12) befindlichen Quelle (2), wie z. B. einem Laser, der eine kohärente elektromagnetische Welle erzeugt, mit einem Detektor (10) für elektromagnetische Wellen und mit Verbindungsmitteln (5, 6, 7, 8), die das zweite Ende des Wellenleiters (18) mit der Quelle (2) verbinden, **dadurch gekennzeichnet, daß** diese Verbindungsmittel einen optischen Zweirichtungskoppler (5) mit einem ersten (6) und einem zweiten (7) Übertragungsweg (6, 7) auf der Eingangsseite und mindestens einem Übertragungsweg (8) auf der Ausgangsseite umfassen, wobei der erste (6) der Übertragungswege (6, 7) der Eingangsseite mit der Quelle (2), der zweite mit dem Detektor (10) und der mindestens eine Übertragungsweg der Ausgangsseite (8) mit dem Wellenleiter (18) verbunden ist, und daß die vom ersten Ende (13) des Wellenleiters (18) emittierte elektromagnetische Welle durch die zu untersuchende Oberfläche (12) so reflektiert wird, daß sie in die Richtung auf das Ende (13) zurückläuft und sich an die Ausbreitungseigenmode des Wellenleiters (18) ankoppelt und dabei unter Durchlaufen des Übertragungsweges der Ausgangsseite (8), des Kopplers (5) und des zweiten Übertragungsweges der Eingangsseite (7) in Richtung auf den Detektor geführt wird, wobei das Ende des Wellenleiters der Oberfläche bis auf einen Abstand so angenähert wird, daß der Kopplungskoeffizient zwischen der Ausbreitungseigenmode des Wellenleiters und der Ausbreitungsmode des elektrischen Feldes der reflektierten Welle in dem Maße, in dem sich das Ende an diese Oberfläche annähert, eine im wesentlichen exponentielle Zunahme zeigt.

10. Nahfeldmikroskop nach Anspruch 9, dadurch gekennzeichnet, daß der Koppler an der Ausgangsseite einen zweiten Übertragungsweg (9) aufweist, der so aufgebaut und angeordnet ist, daß er zur Vornahme einer Referenzmessung der Intensität der von der Quelle (2) emittierten Welle dient.

11. Nahfeldmikroskop nach Anspruch 9, dadurch gekennzeichnet, daß der Detektor (10) über ein Regelsystem (15) mit herkömmlichen Mitteln zur vertikalen Verschiebung (14) des Endes des Wellenleiters verbunden ist.

12. Nahfeldmikroskop nach einem der Ansprüche 9 bis 11, dadurch gekennzeichnet, daß der als optischer Meßfühler dienende Wellenleiter aus einer optischen Faser (18) besteht, die als Übertragungsweg (8) der Ausgangsseite des Optokopplers (5) dient.

13. Nahfeldmikroskop nach Anspruch 12, dadurch gekennzeichnet, daß das Ende (13) der als Wellenleiter dienenden optischen Faser (18) die Form einer ebenen Fläche (19) hat, die im wesentlichen senkrecht zur mittleren Ausbreitungsrichtung des Lichtes in der Faser (18) verläuft.

14. Nahfeldmikroskop nach einem der Ansprüche 12 oder 13, dadurch gekennzeichnet, daß die als Wellenleiter dienende optische Faser (18) an ihrem Ende (13) so ausgezogen ist, daß sie einen Kern (18a) aufweist, dessen Durchmesser der "schmalsten" Hauptausbreitungsmode der elektromagnetischen Welle in der Faser unter den gegebenen Einsatzbedingungen entspricht, welche insbesondere von der Wellenlänge der von der Quelle (2) emittierten elektromagnetischen Welle, der Beschaffenheit der die Übertragungswege (6, 7, 8, 9) des Kopplers (5) bildenden optischen Fasern und der numerischen Apertur der als Wellenleiter dienenden optischen Faser (18) abhängig sind.

15. Nahfeldmikroskop nach einem der Ansprüche 12 bis 14, dadurch gekennzeichnet, daß der Mantel (18b) der als Wellenleiter dienenden optischen Faser (18) am Ende (13) der Faser (18) zugespitzt und somit punktförmig ausgebildet ist, und daß die Endfläche (19) der Faser (18) andererseits eben ist und im wesentlichen senkrecht zur Ausbreitungsrichtung des Lichtes in der Faser (18) verläuft.

16. Nahfeldmikroskop nach Anspruch 12, dadurch gekennzeichnet, daß das Ende (13) der als Wellenleiter dienenden optischen Faser (18) in Form einer ebenen Fläche (19) vorliegt, die mit der mittleren Ausbreitungsrichtung des Lichtes in der Faser (18) einen beträchtlichen Winkel bildet.

**Claims**

1. A method of "near-field" reflection microscopy, of the type in which a surface (12) is scanned by an optical probe (8), particularly such as a wave guide into which an electromagnetic wave, advantageously coherent, is injected, for example from a laser (2), which method is characterised in that the end (13) of this wave guide is brought to a distance (d) from the surface to be studied such that the coupling coefficient between the actual mode of propagation of the wave guide and the mode of propagation of the electrical field of the wave reflected by said surface and guided for return by this same wave guide, has a substantially exponential increase as said end is brought towards this same surface.

2. A method of "near-field" reflection microscopy according to Claim 1, characterised in that the vertical position of the end of the wave guide serving as an optical probe is acted on, in such a way as to hold constant the coupling coefficient between the actual mode of propagation of the wave guide and the mode of propagation of the electrical field of the reflected wave, guided for return by this same wave guide.

3. A method of "near-field" reflection microscopy according to Claim 1, characterised in that the end of the wave guide serving as an optical probe is held at a substantially constant level above the surface to be studied, whilst the variations in the coupling coefficient between the actual mode of propagation of the wave guide and the mode of propagation of the electrical field of the wave reflected by the surface are measured.

4. A method of "near-field" reflection microscopy according to Claim 2, using an optical fibre, preferentially monomode, as a wave guide, characterised in that there is formed, at the end of this optical fibre, a flat face (19) substantially perpendicular to the mean direction of propagation of light in the fibre, then, in that this flat face is positioned above the surface to be studied, in a direction substantially orthogonal to this surface, in conditions such that there is produced a phenomenon of constructive interference between the wave reflected by the surface, and guided for return by the optical fibre, and the wave reflected in this same fibre on its flat output face, and finally, in that the vertical position of this same flat face is reacted on so as to maintain constant the intensity of the electromagnetic wave resulting from this interference phenomenon, even if this intensity has a sinusoidal modulation of constant interfringe distance.

5. A method of "near-field" reflection microscopy according to Claim 4, characterised in that the flat output face of the optical fibre used as a wave guide is positioned above the surface to be studied, in conditions such that the reaction on the vertical position of this same flat face can be effected in an attraction mode, that is to say that the intensity of the electromagnetic wave, resulting from the interference phenomenon between the wave reflected by the surface to be studied and the wave reflected by said flat face, is controlled in the rising portion of a single period of the sinusoidal modulation of this same intensity.

6. A method of "near-field" reflection microscopy according to Claim 4, characterised in that the flat output face of the optical fibre used as a wave guide is positioned above the surface to be studied, in conditions such that the reaction on the vertical position of this same flat face can be effected in a repulsion mode, that is to say that the intensity of the electromagnetic wave, resulting from the interference phenomenon between the wave reflected by the surface to be studied and the wave reflected by said flat face, is controlled in the descending portion of a single period of the sinusoidal modulation of this same intensity.

7. A method of "near-field" reflection microscopy according to Claim 2, using an optical fibre, preferentially monomode, as wave guide, characterised in that there is formed, at the end of this optical fibre, a flat face (19) substantially perpendicular to the mean direction of light propagation in the fibre, then in that this flat face is positioned above the surface to be studied, in a direction making a substantial angle with this same surface, in conditions such that no measurable constructive interference phenomenon can be produced between the wave reflected by the surface and guided in return by the optical fibre, and the wave reflected in this same fibre on its flat output face.

8. A method of "near-field" reflection microscopy according to Claim 2, using an optical fibre, preferentially monomode, as a wave guide, characterised in that there is formed, at the end of this optical fibre, a flat face making a substantial angle with the mean direction of light propagation in the fibre, then, in that this same fibre is positioned above the surface to be studied, in a direction substantially orthogonal to this same surface, in conditions such that no measurable constructive interference phenomenon can be produced between the wave reflected by the surface and guided for return by the optical fibre, and the wave reflected in this same fibre on its flat output face.

9. A "near-field" reflection microscope of the type which scans a surface (12) to be examined, including an optical probe(18) constituting a wave guide having a first end (13) and a second end, means for vertical movement (14) and lateral movement (11) of the probe (18) with a precision less than a nanometre, above the surface (12) to be examined, a source (2) such as a laser generating a coherent electromagnetic wave, an electromagnetic wave detector (10) and connection means (5,6,7,8) joining said second end of the wave guide (18) to the source (2), characterised in that the connection means include a bidirectional optical coupler (5) having a first (6) and a second (7) input transmission paths (6,7) and at least one output transmission path (8), the first (6) of the input transmission paths (6,7) being connected to the source (2), the second being connected to the detector (10), said at least one output transmission path (8) being connected to the wave guide (18), the electromagnetic wave emitted through the first end (13) of the wave guide (18) being reflected by the surface (12) to be examined, in such a way as to return in the direction of this end (13) and to be coupled to the actual mode of propagation of the wave guide (18), whilst being guided towards the detector by passing through the output transmission path (8), the coupler (5) and the second input path (7), the end of the wave guide being brought to a distance from the surface such that the coupling coefficient between the actual mode of propagation of the wave guide and the mode of propagation of the electrical field of the reflected wave has a substantially exponential increase as said end is brought towards this surface.

10. A "near-field" microscope according to Claim 9, characterised in that the coupler has a second output transmission path (9) designed and arranged so as to serve to effect a reference measurement of the intensity of the wave emitted by the source (2).

11. A "near-field" microscope according to Claim 9, characterised in that the detector (10) is connected, by a servo-control system (15), to conventional means (14) for vertical displacement of the end of the wave guide.

12. A "near-field" microscope according to any one of Claims 9 to 11, characterised in that the wave guide serving as optical probe is constituted by an optical fibre (18) serving as a transmission path (8) at the output of the optical coupler (5).

13. A "near-field" microscope according to Claim 12, characterised in that the end (13) of the optical fibre (18) serving as a wave guide is in the form of a flat face (19) substantially perpendicular to the mean direction of light propagation in the fibre (18).

14. A "near-field" microscope according to either of Claims 12 or 13, characterised in that the optical fibre (18) serving as a wave guide is drawn out at its end (13) so as to have a core (18a) of which the diameter corresponds to the "narrowest" principal mode of propagation of an electromagnetic wave in the fibre (18), in given conditions of use, notably dependant on the wavelength of the electromagnetic wave emitted by the source (2), on the nature of the optical fibres constituting the transmission paths (6,7,8,9) of the coupler (5), and on the numerical opening of the optical fibre (18) serving as a wave guide.

15. A "near-field" microscope according to any one of Claims 12 to 14, characterised in that the sheath (18b) of the optical fibre (18) serving as a wave guide is thinned at the end (13) of the fibre (18), which is then in the form of a point, the end face (19) of this fibre (18) being, moreover, flat and substantially perpendicular to the direction of light propagation in the fibre (18).

16. A "near-field" microscope according to Claim 12, characterised in that the end (13) of the optical fibre (18) serving as a wave guide is in the form of a flat face (19) making a substantial angle with the mean direction of light propagation in the fibre (18).

_Fig 1_

_Fig 2_

_Fig 4_

_Fig 3_